# EUROPEAN PATENT APPLICATION

(11) **EP 4 516 854 A1**
(43) Date of publication of application: **05.03.2025**
(21) Application number: 23775057.5
(22) Date of filing: 23.03.2023
(51) Int. Cl.: C08L 25/04, C08K 3/013, C08K 7/02, C08K 7/14, C08L 21/00, C08L 23/02

(54) **SYNDIOTACTIC POLYSTYRENE LOW DIELECTRIC SHEET MOLDED BODY**

(30) Priority: 25.03.2022 JP 2022050489
(71) Applicant: Toyobo Co., Ltd., Kita-ku Osaka-shi, Osaka 530-0001 (JP)
(72) Inventor: MAEDA Yuki, Otsu-shi, Shiga 520-0292 (JP); KURITA Tomoharu, Otsu-shi, Shiga 520-0292 (JP); IRIE Michihiko, Otsu-shi, Shiga 520-0292 (JP); TOGAWA Keiichiro, Osaka-shi, Osaka 530-0001 (JP); HIRONAKA Nobuyuki, Osaka-shi, Osaka 530-0001 (JP)
(74) Representative: Müller-Boré & Partner Patentanwälte PartG mbB
(86) International application number: PCT/JP2023/011656
(87) International publication number: WO 2023/182464

(57) **Abstract**

To provide a sheet molded body that has excellent dielectric characteristics and excellent solder heat resistance and that further exhibits a low dimensional change rate (low heat shrinkability) and a low linear expansion coefficient.

A sheet molded body includes : a styrene-based polymer (A) having a syndiotactic structure; a fibrous filler (C); and a nonfibrous filler (D), wherein the sheet molded body is an unstretched sheet molded body, contains the fibrous filler (C) in amount of 1 to 50 parts by mass per 100 parts by mass of the styrene-based polymer (A) having the syndiotactic structure, and has a relative permittivity, in a frequency band of 10 GHz, of 3 or lower.

## Description

### TECHNICAL FIELD

The present invention relates to an unstretched sheet molded body containing a syndiotactic polystyrene polymer having excellent dielectric characteristics. More specifically, the present invention relates to an unstretched sheet molded body containing the syndiotactic polystyrene polymer and having excellent solder heat resistance, low heat shrinkability, and low linear expandability.

### BACKGROUND ART

In recent years, development, of materials and uses, intended for high-speed information communication as in 5G or the like has been actively conducted, and plastic materials that exhibit low permittivities and dissipation factors in a high-frequency band of 10 GHz or higher have been required in order to increase the transmission speed for information. Among the plastic materials, syndiotactic polystyrene (SPS) resins have excellent dielectric characteristics, and thus, are expected to be increasingly employed for circuit boards required to have high-frequency characteristics, in uses such as printed wiring boards and flexible printed wiring boards.

Such circuit boards are often subjected to high-temperature environments during usage/manufacturing processes. Thus, in general, such circuit boards are required to have high heat resistance and high dimensional stability. The heat resistance mentioned herein refers to, for example, a characteristic of being able to withstand heat treatment conditions (e.g., at 260°C for about 120 seconds) in a soldering step that is included in a manufacturing process for a circuit board or an electronic part.

Patent Document 1 discloses a manufacturing method for a release film formed of a biaxially-oriented plastic film, the manufacturing method including: biaxially stretching a film that contains 80% by weight or higher of a syndiotactic polystyrene-based resin; and subsequently performing heat treatment on the film at a predetermined temperature. In addition, Patent Document 2 discloses a laminated body for a printed wiring board. The laminated body is obtained by stacking 1 to 95% by weight of glass cloth having been subjected to surface treatment with a coupling agent onto 99 to 5% by weight of a molding material, for a printed wiring board, that is made from a styrene-based polymer having a highly syndiotactic structure having a polar group.

### PRIOR ART DOCUMENT

### PATENT DOCUMENT

Patent Document 1: Japanese Patent Publication No.5896753
Patent Document 2: Japanese Laid-Open Patent Publication No. H7-142830

### SUMMARY OF THE INVENTION

### PROBLEMS TO BE SOLVED BY THE INVENTION

However, in order to perform biaxial stretching as described in Patent Document 1, an enormous amount of facility investment is necessary for the stretching and the heat treatment, whereby it becomes difficult to satisfy cost requirements that need to be satisfied at the time of film manufacturing. In addition, although characteristics of the film are improved by oriented crystallization of the film itself owing to the stretching, a strain generated during the stretching cannot be completely eliminated through relaxation, whereby a problem arises in that a high dimensional change rate is exhibited when the film is heated again at a high temperature. Therefore, it is difficult to apply this manufacturing method to uses that require a high dimensional stability as in a circuit board.

The laminated body obtained from stacking glass cloth and a molding material for a printed wiring board described in Patent Document 2 contains, in addition to an SPS modified with a polar group, a large amount of glass cloth that causes dielectric characteristics to significantly deteriorate. Therefore, it is difficult to apply this laminated body as a high-frequency circuit board. In addition, the laminated body has problems in terms of: unevenness of the thickness in an in-plane direction of the sheet; and adhesiveness to the interface with the glass cloth, whereby this technology has low feasibility.

In view of the above circumstances, an object of the present invention is to provide a sheet molded body that has excellent dielectric characteristics and excellent solder heat resistance and that further exhibits a low dimensional change rate (low heat shrinkability) and a low linear expansion coefficient.

### SOLUTIONS TO THE PROBLEMS

Inventors have studied to solve the above-mentioned problems and have arrived at the present invention. Namely, the present invention is a sheet molded body as described in the following claims.
[1] A sheet molded body includes: a styrene-based polymer (A) having a syndiotactic structure; a fibrous filler (C); and a nonfibrous filler (D), wherein the sheet molded body is an unstretched sheet molded body, contains the fibrous filler (C) in amount of 1 to 50 parts by mass per 100 parts by mass of the styrene-based polymer (A) having the syndiotactic structure, and has a relative permittivity, in a frequency band of 10 GHz, of 3 or lower.
[2] The sheet molded body according to [1], further comprising a rubbery elastic body (B), wherein the sheet molded body contains the rubbery elastic body (B) in amount of 1 to 40 parts by mass per 100 parts by mass of the styrene-based polymer (A) having the syndiotactic structure.
[3] The sheet molded body according to [1] or [2], wherein the fibrous filler (C) is made of glass fibers having an average fiber length D50 of 40 to 4000 µm.
[4] The sheet molded body according to any one of [1] to [3], wherein the nonfibrous filler (D) is a particle-form or spherical-form filler having an average particle diameter D50 of 0.1 to 45 µm.
[5] The sheet molded body according to any one of [1] to [4], wherein the rubbery elastic body (B) contains a styrene-based or olefin-based thermoplastic elastomer.
[6] The sheet molded body according to any one of [1] to [5], wherein the sheet molded body has a linear expansion coefficient, in each of a machine direction (MD) and a transverse direction (TD), of 10 to 80 ppm/°C, and a ratio of the linear expansion coefficient in the MD to the linear expansion coefficient in the TD falls in a range of 0.6 to 1.4.
[7] The sheet molded body according to any one of [1] to [6], the sheet molded body exhibiting a dimensional change rate when the sheet molded body is heated at 150°C for 30 minutes, the dimensional change rate having an absolute value of lower than 0.4%.

### EFFECTS OF THE INVENTION

The sheet molded body of the present invention has excellent dielectric characteristics and excellent solder heat resistance and further exhibits a low dimensional change rate (low heat shrinkability) and a low linear expansion coefficient. Therefore, it is possible to provide an excellent sheet molded body that can satisfy a signal speed and a dimensional stability at high temperature that are required of a high-frequency circuit board.

### DESCRIPTION OF EMBODIMENTS

### <Styrene-Based Polymer (A) Having Syndiotactic Structure>

The present invention includes, as a component, a styrene-based polymer (A) having a syndiotactic structure (hereinafter, also referred to as "SPS", "syndiotactic polystyrene", or "component (A)"), and the syndiotactic structure refers to a three-dimensional chemical structure having a syndiotactic configuration, i.e., a three-dimensional configuration in which phenyl groups as side chains are alternately located in opposite directions on a main chain formed by carbon-carbon bonds. The tacticity of the syndiotactic structure is quantified according to the nuclear magnetic resonance (C-NMR) method with isotopic carbon. The tacticity measured according to the C-NMR method can be expressed as the proportion of a plurality of existing consecutive constituent units. For example, in a case where the number of the constituent units is two, the tacticity can be expressed with dyad. Meanwhile, in a case where the number of the constituent units is three, the tacticity can be expressed with triad. Meanwhile, in a case where the number of the constituent units is five, the tacticity can be expressed with pentad. The styrene-based polymer having the syndiotactic structure in the present invention refers to: polystyrene, a poly(alkylstyrene), a poly(halogenated styrene), a poly(halogenated alkylstyrene), a poly(alkoxystyrene), or a poly(vinylbenzoate) each of which has a syndiotacticity of preferably 75 mol% or higher and more preferably 85 mol% or higher in terms of racemic dyad or has a syndiotacticity of preferably 30 mol% or higher and more preferably 50 mol% or higher in terms of racemic pentad; a hydrogenated polymer of any of these styrene-based polymers; a mixture of these styrene-based polymers; or a copolymer containing any of these styrene-based polymers as a main component.

Here, examples of the poly(alkylstyrene) include poly(methylstyrene), poly(ethylstyrene), poly(isopropylstyrene), poly(tert-butylstyrene), poly(phenylstyrene), poly(vinylnaphthalene), poly(vinylstyrene), and the like. Examples of the poly(halogenated styrene) include poly(chlorostyrene), poly(bromostyrene), poly(fluorostyrene), and the like. Examples of the poly(halogenated alkylstyrene) include poly(chloromethylstyrene) and the like. Examples of the poly(alkoxystyrene) include poly(methoxystyrene), poly(ethoxystyrene), and the like.

Examples of particularly preferable styrene-based polymers among these styrene-based polymers include polystyrene, poly(p-methylstyrene), poly(m-methylstyrene), poly(p-tert-butylstyrene), poly(p-chlorostyrene), poly(m-chlorostyrene), poly(p-fluorostyrene), hydrogenated polystyrene, and copolymers containing these structural units.

The styrene-based polymer (A) having the syndiotactic structure may be a copolymer composed of styrene having the syndiotactic structure and another monomer. The amount of the styrene having the syndiotactic structure contained in the component (A) is preferably 50% by mass or higher. The amount is more preferably 60% by mass or higher, further preferably 70% by mass or higher, even more preferably 80% by mass or higher, particularly preferably 90% by mass or higher, and most preferably 100% by mass. When the amount of the contained styrene having the syndiotactic structure is 50% by mass or higher, excellent dielectric characteristics, solder heat resistance, dimensional change rate, and linear expansion coefficient are obtained.

In particular, an unsaturated nitrile group-containing monomer might lead to decrease in these performances, and thus the amount of the contained unsaturated nitrile group-containing monomer is preferably small. Specifically, the amount of the contained unsaturated nitrile group-containing monomer is preferably 2% by mass or lower, more preferably lower than 2% by mass, further preferably 1% by mass or lower, and particularly preferably 0% by mass.

These types of styrene-based polymers (A) having syndiotactic structures may be used singly, or two or more of these types of styrene-based polymers may be mixed and used. The composition ratio of the styrene copolymer is not particularly limited, but the amount of a substituted styrene unit contained in the styrene copolymer is preferably in a range of 3 to 50 mol%. When the amount is 3 mol% or higher, modification is easily performed. Meanwhile, when the amount is 50 mol% or lower, compatibility with the other components can be maintained.

The molecular weight of the styrene-based polymer (A) having the syndiotactic structure is not particularly limited, but the weight-average molecular weight thereof is preferably 10,000 or more, more preferably 50,000 or more, and further preferably 100,000 or more. Regarding the molecular weight distribution of the styrene-based polymer (A) as well, there is no restriction as to the width of the molecular weight distribution, and various components can be blended. When the weight-average molecular weight is set to 10,000 or more, thermal properties and mechanical properties of the obtained composition or molded product do not decrease, and a composition or molded product having favorable thermal properties and mechanical properties is obtained. The upper limit of the weight-average molecular weight is not particularly limited, but the weight-average molecular weight is preferably 500,000 or lower and more preferably 400,000 or lower.

Such a styrene-based polymer (A) having the syndiotactic structure can be manufactured by, for example, polymerizing a styrene-based monomer (a monomer corresponding to the above styrene-based polymer) in an inert hydrocarbon solvent or in the absence of a solvent by using, as catalysts, a titanium compound and a condensation product of water and a trialkyl aluminum (Japanese Laid-Open Patent Publication No. S62-187708). In addition, the poly(halogenated alkylstyrene) can be obtained according to, for example, a method described in Japanese Laid-Open Patent Publication No. H1-46912, and a hydrogenated polymer of any of these styrene-based polymers can be obtained according to, for example, a method described in Japanese Laid-Open Patent Publication No. H1-178505.

The styrene-based polymer (A) having the syndiotactic structure has a melt flow rate (MFR) measured at a temperature of 300°C and at a load of 1.2 kg. The melt flow rate is preferably 1 to 60 g/10 min, more preferably 2 to 40 g/10 min, further preferably 3 to 30 g/10 min, and most preferably 4 to 20 g/10 min. When the melt flow rate is set to fall in the above range, a sheet having favorable physical properties is obtained, and the thickness of the sheet can be made even.

Examples of representative commercially available products of the styrene-based polymer (A) having the syndiotactic structure used in the present invention include XAREC (registered trademark) 142ZE, XAREC (registered trademark) 300ZC, XAREC (registered trademark) 130ZC, and XAREC (registered trademark) 90ZC manufactured by Idemitsu Kosan Co., Ltd., and the like. These types of resins may be used singly, or two or more of these types of resins may be mixed and used.

The styrene-based polymer (A) having the syndiotactic structure may be a styrene-based polymer that has not been modified with a compound having a polar group (hereinafter, also referred to as "unmodified component (A)") or may be a styrene-based polymer that has been modified with such a compound (hereinafter, also referred to as "modified component (A)"). As the component (A), the unmodified component (A) may be used alone, the modified component (A) may be used alone, or a mixture of the unmodified component (A) and the modified component (A) may be used. It is preferable that: the unmodified component (A) is used alone; or a mixture of the unmodified component (A) and the modified component (A) is used. It is more preferable that the unmodified component (A) is used alone. The amount of the component (A) contained in the sheet molded body is the total amount of the unmodified component (A) and the modified component (A). The modification amount of the modified component (A) is preferably higher than 0.01% by mass, more preferably 0.1% by mass or higher, and further preferably 1.0% by mass or higher. When the styrene-based polymer (A) having the syndiotactic structure is modified by a modification amount that falls in the above range, affinity between the unmodified component (A) and each of a fibrous filler (C) and a nonfibrous filler (D) is improved.

The blending amount of the modified component (A) is in a range of preferably 0.01 to 40% by mass and more preferably 0.05 to 30% by mass with respect to the total amount of the component (A). When the blending amount is set to 0.01% by mass or higher, an effect of a compatibilizer can be exhibited. In addition, it becomes unnecessary to cause a large amount of the component to be contained, and no adverse influence is inflicted on mechanical characteristics and heat resistance of the composition. Meanwhile, when the blending amount is set to 40% by mass or lower, the dielectric characteristics can be prevented from decreasing.

The compound having a polar group is not particularly limited, and examples of the compound include maleic acid, phthalic acid, glycidyl (meth)acrylate, acid anhydrides and esters of these compounds, amines, and the like. Examples of the modified component (A) include maleic anhydride-modified SPS, fumaric acid-modified SPS, glycidyl methacrylate-modified SPS, amine-modified SPS, and the like.

### <Rubbery Elastic Body (B)>

A rubbery elastic body (B) (hereinafter, also referred to as "component (B)") is preferably blended since the rubbery elastic body (B) allows, when the sheet is being wound, the sheet to exhibit moderate flexibility and leads to improvement of mechanical properties so that the sheet can be inhibited from being broken. Examples of the rubbery elastic body (B), i.e., component (B), include: homopolymers each formed from a polyolefin, polystyrene, or polyacrylate; and compositions each formed from a plurality of copolymers containing these components. Specific examples of the rubbery elastic body include natural rubbers, polybutadiene, polyisoprene, polyisobutylene, neoprene, polysulfide rubbers, Thiokol rubbers, acrylic rubbers, urethane rubbers, silicone rubbers, epichlorohydrin rubbers, ethylene-propylene copolymer rubbers (EPM), ethylene-propylene-diene copolymer rubbers (EPDM), ethylene-α-olefin copolymer rubbers, styrene-butadiene block copolymers (SBR), hydrogenated styrene-butadiene block copolymers (SEB, SEBC), styrene-butadiene-styrene block copolymers (SBS), hydrogenated styrene-butadiene-styrene block copolymers (SEBS), styrene-isoprene block copolymers (SIR), hydrogenated styrene-isoprene block copolymers (SEP), styrene-isoprene-styrene block copolymers (SIS), hydrogenated styrene-isoprene-styrene block copolymers (SEPS), butadiene-acrylonitrile-styrene core-shell rubbers (ABS), methyl methacrylate-butadiene-styrene core-shell rubbers (MBS), methyl methacrylate-butyl acrylate-styrene core-shell rubbers (MAS), octyl acrylate-butadiene-styrene core-shell rubbers (MABS), alkyl acrylate-butadiene-acrylonitrile-styrene core-shell rubbers (AABS), butadiene-styrene core-shell rubbers (SBR), siloxane-containing core-shell rubbers such as methyl methacrylate-butyl acrylate-siloxane, and other core-shell-type particulate elastic materials, rubbers obtained by modifying these rubbery elastic bodies, and the like.

Among these rubbery elastic bodies, SEBS, SIR, SEP, SIS, SEPS, ethylene-α-olefin copolymer rubbers, or rubbers obtained by modifying these rubbery elastic bodies are particularly preferably used. These types of rubbery elastic bodies may be used singly, or two or more of these types of rubbery elastic bodies may be used in combination. A rubbery elastic body having a high heat resistance is preferable from the viewpoint of a processing temperature at which the rubbery elastic body is mixed with the styrene-based polymer (A) having the syndiotactic structure. By mixing a rubbery elastic body in which an unsaturated bond moiety has been selectively or completely hydrogenated, a smaller amount of gas is generated at the time of hot pressing, and the mechanical properties of the sheet molded body can be maintained even when the sheet molded body is subjected to a high-temperature environment.

The rubbery elastic body (B) has a melt flow rate (MFR) measured at a temperature of 230°C and at a load of 2.16 kg. The melt flow rate of the rubbery elastic body (B) is preferably 0.1 to 40 g/10 min, more preferably 1.0 to 20 g/10 min, and further preferably 1.5 to 14 g/10 min. When the melt flow rate is set to fall in the above range, compatibility with the styrene-based polymer (A) having the syndiotactic structure is improved, and the thickness of the sheet can be made even.

In a case where the rubbery elastic body (B) is contained, the amount of the rubbery elastic body (B) contained in 100 parts by mass of the styrene copolymer (A) having the syndiotactic structure is preferably 1 to 40 parts by mass. The amount is more preferably 3 to 30 parts by mass and further preferably 5 to 25 parts by mass. When the amount of the contained component (B) is set to 1 part by mass or more, the flexibility of the sheet molded body is improved, and the windability thereof around a roll becomes favorable. In addition, drillability in a subsequent step is improved. Meanwhile, when the amount of the contained component (B) is set to 40 parts by mass or less, the sheet molded body can be inhibited from being excessively softened and can be prevented from sticking to a roll, and heat resistance required of a high-frequency circuit board can be maintained.

It is also preferable that the rubbery elastic body (B) contains a styrene-based thermoplastic elastomer. In a case where the rubbery elastic body (B) is a styrene-based thermoplastic elastomer, the styrene content of the styrene-based thermoplastic elastomer is preferably 5 to 60% by mass. The styrene content is more preferably 8 to 50% by mass, further preferably 10 to 40% by mass, and particularly preferably 15 to 32% by mass. When the styrene content is set to 5% by mass or higher, compatibility between the component (A) and the component (B) is improved, and the mechanical properties become favorable. Meanwhile, when the styrene content is set to 60% by mass or lower, the elastic modulus of the component (B) is not excessively increased, and thus the effect of eliminating stress through relaxation is improved, whereby the flexibility of the sheet molded body becomes favorable. Furthermore, the polarity of the sheet molded body is decreased, and increase in the permittivity thereof can be suppressed.

### <Fibrous Filler (C)>

A fibrous filler (C) (hereinafter, also referred to as "component (C)") is a fibrous filler that can improve the effect of decreasing a linear expansion coefficient and a dimensional change in a direction (MD) parallel to an extrusion direction of the sheet molded body. The fibrous filler (C) is a filler necessary for the sheet molded body of the present invention that might sustain non-negligible residual strain although the sheet molded body is unstretched. As the fibrous filler (C), inorganic fibers or organic fibers may be used. In the case of inorganic fibers, wollastonite (or whisker) or glass fibers may be used, and glass fibers are particularly preferable from the viewpoint of the dielectric characteristics. The amount of the fibrous filler (C) contained per 100 parts by mass of the styrene-based polymer (A) having the syndiotactic structure is 1 to 50 parts by mass in order to attain balance between a target linear expansion coefficient and each of dimensional stability, impact resistance, and mechanical properties. The amount is preferably 3 to 40 parts by mass and more preferably 5 to 30 parts by mass.

The fibrous filler (C) may be used in the form of any of a roving, a surfacing mat, a chopped strand mat, a sateen weave, a lattice weave, a plain weave, a perforated plain weave, a twill weave, a net, and the like. Regarding the type of the fibrous filler (C), a fibrous filler (C) of any type such as glass containing a large amount of alkali (C-glass) or alkali-free glass (E-glass) may be used.

Glass containing a large amount of boric acid (D-glass) or glass obtained by adjusting balance between silicic acid and boric acid (NE-glass) is further preferably used. The D-glass preferably contains SiO₂ and B₂O₃, the SiO₂ content of the D-glass is preferably in a range of 65.0 to 80.0% by mass, and in this case, the B₂O₃ content of the D-glass is preferably in a range of 15.0 to 30.0% by mass. The NE-glass preferably contains SiO₂ and B₂O₃, the SiO₂ content of the NE-glass is preferably in a range of 45.0 to 65.0% by mass, and in this case, the B₂O₃ content of the NE-glass is preferably in a range of 10.0 to 25.0% by mass.

As the fibrous filler (C), glass fibers having circular cross-sectional shapes or non-circular cross-sectional shapes may be used. Examples of the glass fibers having non-circular cross-sectional shapes include glass fibers each having a substantially elliptical shape, a substantially oval shape, or a substantially cocoon shape in a cross section perpendicular to the length direction of the fiber. In each of these examples, the degree of flattening is preferably 1.5 to 8. Here, when a rectangular shape having a minimum area and circumscribing the cross section perpendicular to the longitudinal direction of the glass fiber is assumed, and the length of a long side of the rectangular shape and the length of a short side of the rectangular shape are respectively defined as a major axis and a minor axis, the degree of flattening is the ratio of the major axis to the minor axis. The thickness of the glass fiber is not particularly limited, but the minor axis is about 1 to 20 µm, and the major axis is about 2 to 100 µm. Each of the glass fibers having circular cross-sectional shapes has a fiber diameter (diameter) of preferably 1 to 50 µm, more preferably 2 to 20 µm, and further preferably 3 to 15 µm.

The fibrous filler (C) has an average fiber length D50 of preferably 40 µm to 4000 µm, more preferably 40 µm to 3200 µm, further preferably 45 µm to 2000 µm, and most preferably 50 µm to 500 µm. When the average fiber length D50 is 40 µm or more, the surface area of the fibrous filler (C) becomes sufficiently large, the adhesiveness at the interface between the component (A) as a matrix resin and the component (C) is improved, and the physical properties of the sheet molded body become favorable. Meanwhile, when the average fiber length D50 is set to 4000 µm or less, the rigidity at the time of film formation of the sheet molded body can be inhibited from becoming excessively high, and generation of cracks that might be noticed at the time of winding of the sheet can be suppressed. Furthermore, generation of aggregates in the sheet molded body can be suppressed.

The fibrous filler (C) may be or does not have to be subjected to surface treatment. In a case where the fibrous filler (C) is subjected to surface treatment, examples of a coupling agent used for the surface treatment can include silane-based coupling agents, titanium-based coupling agents, and the like. Among these coupling agents, a silane-based coupling agent is particularly preferably used for performing the surface treatment from the viewpoint of compatibility with the component (A). Specific examples of the silane-based coupling agents include triethoxysilane, vinyltris(β-methoxyethoxy)silane, γ-methacryloxypropyltrimethoxysilane, γ-glycidoxypropyltrimethoxysilane, β-(1,1-epoxycyclohexyl)ethyltrimethoxysilane, N-β-(aminoethyl)-γ-aminopropyltrimethoxysilane, N-β-(aminoethyl)-γ-aminopropylmethyldimethoxysilane, γ-aminopropyltriethoxysilane, N-phenyl-γ-aminopropyltrimethoxysilane, γ-mercaptopropyltrimethoxysilane, γ-chloropropyltrimethoxysilane, γ-aminopropyltrimethoxysilane, γ-aminopropyl-tris(2-methoxy-ethoxy)silane, N-methyl-γ-aminopropyltrimethoxysilane, N-vinylbenzyl-γ-aminopropyltriethoxysilane, 3-ureidopropyltrimethoxysilane, 3-4,5-dihydroimidazolpropyltriethoxysilane, hexamethyldisilazane, N,N-bis(trimethylsilyl)urea, 3-triethoxysilyl-N-(1,3-dimethyl-butylidene)propylamine, and the like. Among these silane-based coupling agents, aminosilanes and epoxy silanes such as γ-aminopropyltrimethoxysilane, N-β-(aminoethyl)-γ-aminopropyltrimethoxysilane, γ-glycidoxypropyltrimethoxysilane, and β-(3,4-epoxycyclohexyl)ethyltrimethoxysilane are preferable.

Specific examples of the titanium-based coupling agents include isopropyl triisostearoyl titanate, isopropyl tridodecylbenzene sulfonyl titanate, isopropyl tris(dioctyl pyrophosphate)titanate, tetraisopropyl bis(dioctyl phosphite)titanate, tetraoctyl bis(ditridecyl phosphite)titanate, tetra(1,1-diallyloxymethyl-1-butyl)bis(ditridecyl)phosphite titanate, bis(dioctyl pyrophosphate)oxyacetate titanate, bis(dioctyl pyrophosphate)ethylene titanate, isopropyl trioctanoyl titanate, isopropyl dimethacrylisostearoyl titanate, isopropyl isostearoyl diacrylic titanate, isopropyl tri(dioctyl phosphate)titanate, isopropyl tricumylphenyl titanate, isopropyl tri(N-amidoethyl, aminoethyl)titanate, dicumylphenyloxyacetate titanate, diisostearoyl ethylene titanate, and the like. Among these titanium-based coupling agents, isopropyl tri(N-amidoethyl, aminoethyl)titanate is preferable.

The process for performing surface treatment on the fibrous filler (C) by using the above coupling agent is not particularly limited. For example, it is possible to perform surface treatment through any of processes suitable for the shape of the fibrous filler (C), such as: a sizing process in which an organic solvent solution or a suspension of the above coupling agent is applied as a sizing agent onto the fibrous filler (C); a dry mixing process in which a Henschel mixer, the SUPERMIXER, the Loedige Mixer, a V-shaped blender, or the like is used; or a process performed through a spray method, an integral blending method, or a dry concentration method. Among these processes, the surface treatment is preferably performed through the sizing process, the dry mixing process, or the process performed through the spray method. In combination with the above coupling agent, for example, a film-forming substance for glass may be used. The film-forming substance is not particularly limited, and examples thereof include polyester-based polymers, urethane-based polymers, epoxy-based polymers, acrylic-based polymers, vinyl acetate-based polymers, polyether-based polymers, and other polymers.

As a compatibilizer for the fibrous filler (C), a modified polymer may be used separately from the styrene-based polymer (A) having the syndiotactic structure. By adding a compatibilizer, the strength at the interface between the syndiotactic polystyrene-based polymer (A) and each of the fibrous filler (C) and the nonfibrous filler (D) is improved, and thus the compatibilizer is blended for this purpose.

Specific examples of the compatibilizer include styrene-maleic anhydride copolymers (SMA), styrene-glycidyl methacrylate copolymers, terminal carboxylic acid-modified polystyrenes, terminal epoxy-modified polystyrenes, terminal oxazoline-modified polystyrenes, terminal amine-modified polystyrenes, sulfonated polystyrenes, styrene-based ionomers, styrene-methyl methacrylate-graft polymers, (styrene-glycidyl methacrylate)-methyl methacrylate-graft copolymers, acid-modified acrylic-styrene-graft polymers, (styrene-glycidyl methacrylate)-styrene-graft polymers, polybutylene terephthalate-polystyrene-graft polymers, polyphenylene ethers, (styrene-maleic anhydride)-polyphenylene ether-graft polymers, maleic anhydride-modified polyphenylene ethers, fumaric acid-modified polyphenylene ethers, glycidyl methacrylate-modified polyphenylene ethers, amine-modified polyphenylene ethers, and other modified polyphenylene ether-based polymers, and the like. Among these compatibilizers, unmodified or modified polyphenylene ethers are suitable, and maleic anhydride-modified polyphenylene ethers and fumaric acid-modified polyphenylene ethers are more suitable.

Each of the above modified polyphenylene ethers can be obtained by modifying a publicly-known polyphenylene ether with a modifier, but the method for obtaining the modified polyphenylene ether is not limited thereto as long as the obtained modified polyphenylene ether can be used for the purpose of the present invention. This polyphenylene ether is a publicly-known compound, and for this purpose, the specifications of US Patent No. 3,306,874, US Patent No. 3,306,875, US Patent No. 3,257,357, and US Patent No. 3,257,358 may be referred to. The polyphenylene ether is ordinarily prepared through an oxidative coupling reaction by using a disubstituted or trisubstituted phenol in the presence of a copper-amine complex as a catalyst. As the copper-amine complex, a copper-amine complex derived from any of primary, secondary, and tertiary amines may be used.

Examples of the polyphenylene ether include poly(2,3-dimethyl-6-ethyl-1,4-phenylene ether), poly(2-methyl-6-chloromethyl-1,4-phenylene ether), poly(2-methyl-6-hydroxyethyl-1,4-phenylene ether), poly(2-methyl-6-n-butyl-1,4-phenylene ether), poly(2-ethyl-6-isopropyl-1,4-phenylene ether), poly(2-ethyl-6-n-propyl-1,4-phenylene ether), poly(2,3,6-trimethyl-1,4-phenylene ether), poly[2-(4'-methylphenyl)-1,4-phenylene ether], poly(2-bromo-6-phenyl-1,4-phenylene ether), poly(2-methyl-6-phenyl-1,4-phenylene ether), poly(2-phenyl-1,4-phenylene ether), poly(2-chloro-1,4-phenylene ether), poly(2-methyl-1,4-phenylene ether), poly(2-chloro-6-ethyl-1,4-phenylene ether), poly(2-chloro-6-bromo-1,4-phenylene ether), poly(2,6-di-n-propyl-1,4-phenylene ether), poly(2-methyl-6-isopropyl-1,4-phenylene ether), poly(2-chloro-6-methyl-1,4-phenylene ether), poly(2-methyl-6-ethyl-1,4-phenylene ether), poly(2,6-dibromo-1,4-phenylene ether), poly(2,6-dichloro-1,4-phenylene ether), poly(2,6-diethyl-1,4-phenylene ether), poly(2,6-dimethyl-1,4-phenylene ether), and the like.

For example, a copolymer derived from two or more types of phenol-based compounds used for preparing the above polyphenylene ether, or the like may also be used. Other examples are a graft copolymer and a block copolymer of an aromatic vinyl compound such as polystyrene and the above polyphenylene ether. Poly(2,6-dimethyl-1,4-phenylene ether) is particularly preferably used.

Examples of the modifier used for modifying the polyphenylene ether include a compound having an ethylenic double bond and a polar group in the same molecule thereof. Specific examples of the modifier include maleic anhydride, maleic acid, fumaric acid, maleic acid esters, fumaric acid esters, maleimide and N-substituted products thereof, maleic acid salts, fumaric acid salts, acrylic acid, acrylic acid esters, acrylamide, acrylic acid salts, methacrylic acid, methacrylic acid esters, methacrylamide, methacrylic acid salts, glycidyl methacrylate, and the like. Among these modifiers, maleic anhydride, fumaric acid, and glycidyl methacrylate are particularly preferably used. The above various types of modifiers may be used singly, or two or more of these types of modifiers may be used in combination.

The modified polyphenylene ether is obtained by, for example, reacting the above polyphenylene ether and the above modifier in the presence of a solvent or another resin. The method for the modification is not particularly limited, and a publicly-known method may be employed. Specific examples of the method can include: a method that includes causing a reaction through melt-kneading at a temperature in a range of 150 to 3 50°C by using a roll mill, a Banbury mixer, an extruder, or the like; a method that includes causing a heating reaction in a solvent such as benzene, toluene, or xylene; and the like. In order to facilitate the reaction, it is also effective to further add a radical generator such as benzoyl peroxide, di-tert-butyl peroxide, dicumyl peroxide, tert-butyl peroxybenzoate, azobisisobutyronitrile, azobisisovaleronitrile, or 2,3-diphenyl-2,3-dimethylbutane such that the radical generator is present in the reaction system. A method that includes performing melt-kneading in the presence of the radical generator is particularly preferable.

The amount of the polar group contained in the above polyphenylene ether is desirably in a range of 0.01 to 20% by mass and preferably 0.05 to 10% by mass. When the amount is lower than 0.01% by mass, the effect of the compatibilizer is not sufficiently exhibited. Meanwhile, when the amount is higher than 20% by mass, compatibility with the styrene-based polymer (A) having the syndiotactic structure decreases. The blending amount of the above polyphenylene ether is 0.1 to 10% by mass and preferably 0.5 to 8% by mass with respect to the total weight of the resin components. When the blending amount is lower than 0.1% by mass, the effect of the compatibilizer might become insufficient. Meanwhile, when the blending amount is higher than 20% by mass, the heat resistance of the composition might significantly decrease.

### [Nonfibrous Filler (D)]

Anonfibrous filler (D) (hereinafter, also referred to as "component (D)") is a nonfibrous filler expected to exhibit the effect of decreasing the linear expansion coefficient and the dimensional change in each of the direction (MD) parallel to the extrusion direction of the sheet molded body and the direction (TD) perpendicular to said extrusion direction. As the nonfibrous filler (D), a nonfibrous filler having a publicly-known form such as a spherical form, a particle form, or a plate form may be used. The nonfibrous filler (D) may be inorganic or organic, but is preferably an inorganic spherical-form, particle-form, or plate-form filler. Examples of such a filler include talc, carbon black, graphite, titanium dioxide, silica, mica, calcium carbonate, calcium sulfate, barium carbonate, magnesium carbonate, magnesium sulfate, barium sulfate, oxysulfate, tin oxide, alumina, kaolin, silicon carbide, metal powder, glass powder, glass flakes, glass beads, and the like.

Among these inorganic fillers, silica is particularly preferable, and amorphous silica or fused silica is more preferable from the viewpoint of productivity, cost, and the dielectric characteristics of the filler itself. Amorphous silica has a lower hardness and can lead to a smaller extent of wear of a machine or a screw than crystalline silica.

Fused silica is obtained by melting a raw material in flame and rapidly cooling and solidifying volatilized gas, so as to be made into a spherical form owing to surface tension. Consequently, the fused silica has few pointed portions, the filler itself is not prone to collapsing, and a stable form is easily obtained.

The form of the silica is preferably a particle form or a spherical form, and further preferably a spherical form. When the form of the silica is a particle form or a spherical form, the silica is easily mixed when being added into molten resin. In addition, the silica is kept stable regardless of the direction in which force is exerted thereto, and thus decrease in the mechanical properties of the sheet molded body is suppressed, and the silica is less likely to come off from the sheet molded body as a result of being fractured.

The nonfibrous filler (D) preferably has an average particle diameter D50 of 0.1 to 45 µm. The average particle diameter D50 is more preferably 0.2 to 30 µm and further preferably 0.3 to 20 µm. When the average particle diameter D50 is 0.1 µm or more, aggregation between the particles of the component (D) is suppressed, the nonfibrous filler (D) does not form foreign matter in the sheet molded body, and mechanical characteristics do not decrease. Meanwhile, when the average particle diameter D50 is 45 µm or less, gaps between the particles of the component (D) are prevented from being excessively narrowed, and extension of cracks at interfaces can be suppressed at the time of generation of stress. In addition, the heat resistance in a soldering step can be maintained.

The amount of the nonfibrous filler (D) contained per 100 parts by mass of the polystyrene-based polymer (A) having the syndiotactic structure is preferably 1 to 60 parts by mass. The amount of the nonfibrous filler (D) is more preferably 3 to 50 parts by mass and further preferably 5 to 40 parts by mass. When the amount of the nonfibrous filler (D) is 1 part by mass or more, the effect of the component (D) can be exhibited. Meanwhile, when the amount of the nonfibrous filler (D) is set to 60 parts by mass or less, the smoothness of a surface of the sheet molded body becomes favorable, and the thickness of the sheet can be made easy to control. Moreover, aggregation between the particles of the component (D) in the sheet molded body can be suppressed, and decrease in the mechanical properties can be suppressed.

In a case where the amorphous or fused silica has hollow shapes, the above description does not apply. By using hollow silica, the permittivity is expected to be further decreased. In the case of using hollow silica, a wall thickness of the hollow silica is in a range of preferably 0.5 to 2.0 µm, more preferably 0.5 to 1.5 µm, and further preferably 0.5 to 1.2 µm. With an excessively small wall thickness of the hollow silica, when screw-mixing is performed in a twin-screw kneader, the silica might be broken and the hollow shape might not be able to be retained. Meanwhile, with an excessively large wall thickness of the hollow silica, the volume fraction of the hollow portion decreases, whereby the effect of decreasing the permittivity might become unable to be exhibited. The hollow silica has an average particle diameter D50 in a range of preferably 3 to 45 µm. When the average particle diameter D50 is less than 3 µm, the effect of decreasing the permittivity cannot be expected to be exhibited. Meanwhile, when the average particle diameter D50 is more than 45 µm, the mechanical properties of the sheet molded body might decrease.

Both a nonfibrous filler (D) that has been subjected to surface treatment and a nonfibrous filler (D) that has not been subjected to surface treatment may be used. Although an agent for the surface treatment is not limited as far as the agent is publicly known, execution of hydrophobization treatment with a silane-based or titanate-based coupling agent leads to obtainment of a favorably dispersed state in the styrene polymer (A) having the syndiotactic structure and improvement of the mechanical properties of the sheet and enables suppression of generation of aggregates.

The polymer to be used for the organic spherical-form, particle-form, or plate-form filler is not particularly limited. However, in consideration of a processing temperature for the styrene-based resin (A) having the syndiotactic structure, the following polymers are preferable. On one hand, in the case of a crystalline resin, a polymer having a melting point of higher than 280°C is preferable, and a polymer having a melting point of higher than 300°C is further preferable. On the other hand, in the case of an amorphous resin, a polymer having a glass transition temperature of higher than 150°C is preferable, and a polymer having a glass transition temperature of higher than 180°C is further preferable. When the melting point and the glass transition temperature are set to fall in the above respective ranges, the form of the filler can be retained even at the time of processing the sheet molded body, and the effect of decreasing the linear expansion coefficient of the sheet molded body can be exhibited.

### <Antioxidant (E)>

The sheet molded body of the present invention may contain the following antioxidant (E) (hereinafter, also referred to as "component (E)") from the viewpoint of processability. The antioxidant (E) in the present invention may be either a primary antioxidant for preventing oxidation by capturing generated radicals or a secondary antioxidant for preventing oxidation by decomposing a generated peroxide. Examples of the primary antioxidant include phenol-based antioxidants and amine-based antioxidants, and examples of the secondary antioxidant include phosphorus-based antioxidants and sulfur-based antioxidants. By blending these antioxidants singly or in combination, decrease in the molecular weight of the component (A) or (B) at the time of manufacturing the SPS resin composition can be suppressed, and gas derived from the component (A) or (B) can be inhibited from being generated in a hot-pressing step at the time of manufacturing the sheet molded body.

Specific examples of the phenol-based antioxidants include monophenol-based antioxidants such as 2,6-di-t-butyl-4-methylphenol, 2,6-di-t-butyl-4-ethylphenol, 2-t-butyl-4-methoxyphenol, 3-t-butyl-4-methoxyphenol, 2,6-di-t-butyl-4-[4,6-bis(octylthio)-1,3,5-triazin-2-ylamino]phenol, and n-octadecyl-3-(3,5-di-t-butyl-4-hydroxyphenyl)propionate. Other examples of the phenol-based antioxidants include bisphenol-based antioxidants such as 2,2'-methylenebis(4-methyl-6-t-butylphenol), 2,2'-methylenebis(4-ethyl-6-t-butylphenol), 4,4'-thiobis(3-methyl-6-t-butylphenol), 4,4'-butylidenebis(3-methyl-6-t-butylphenol), N,N'-bis[3-(3,5-di-t-butyl-4-hydroxyphenyl)propionyl]hydrazine, N,N'-hexane-1,6-diylbis[3-(3,5-di-t-butyl-4-hydroxyphenyl)propionamide], and 3,9-bis[1,1-dimethyl-2-[β-(3-t-butyl-4-hydroxy-5-methylphenyl)propionyloxy]ethyl]-2,4,8,10-tetraoxaspiro[5.5]undecane. Other examples of the phenol-based antioxidants include high-molecular-weight phenol-based antioxidants such as 1,1,3-tris(2-methyl-4-hydroxy-5-t-butylphenyl)butane, 1,3,5-trimethyl-2,4,6-tris(3,5-di-t-butyl-4-hydroxybenzyl)benzene, pentaerythritol tetrakis[3-(3,5-di-t-butyl-4-hydroxyphenyl)propionate], bis[3,3'-bis-(4'-hydroxy-3'-t-butylphenyl)butyric acid]glycol ester, 1,3,5-tris(3',5'-di-t-butyl-4'-hydroxybenzyl)-sec-triazine-2,4,6-(1H,3H,5H)trione, and d-α-tocopherol.

Specific examples of the amine-based antioxidants include alkyl-substituted diphenylamines and the like.

Specific examples of the phosphorus-based antioxidants include triphenyl phosphite, diphenyl isodecyl phosphite, phenyl diisodecyl phosphite, 4,4'-butylidene-bis(3-methyl-6-t-butylphenyl ditridecyl)phosphite, octadecyl phosphite, tris(nonylphenyl)phosphite, diisodecyl pentaerythritol diphosphite, 9,10-dihydro-9-oxa-10-phosphaphenanthrene-10-oxide, 10-(3,5-di-t-butyl-4-hydroxybenzyl)-9,10-dihydro-9-oxa-10-phosphaphenanthrene-10-oxide, 10-decyloxy-9,10-dihydro-9-oxa-10-phosphaphenanthrene, tris(2,4-di-t-butylphenyl)phosphite, cyclic neopentane tetrayl bis(2,4-di-t-butylphenyl)phosphite, cyclic neopentane tetrayl bis(2,6-di-t-butyl-4-methylphenyl)phosphite, 2,2'-methylenebis(4,6-di-t-butylphenyl)octyl phosphite, and the like.

Specific examples of the sulfur-based antioxidants include dilauryl-3,3'-thiodipropionate, dimyristyl-3,3'-thiodipropionate, distearyl-3,3'-thiodipropionate, pentaerythritol tetrakis(3-laurylthiopropionate), 2-mercaptobenzimidazole, and the like.

From the viewpoint of the heat resistance of the sheet and from the viewpoint of enabling suppression of thermal degradation at the time of processing, the antioxidant is preferably any of the primary antioxidants among which the phenol-based antioxidants are particularly preferable. The antioxidant has a pyrolysis temperature of preferably 250°C or higher. When the pyrolysis temperature is high, the effect of improving a dielectric breakdown voltage at a high temperature becomes high. When the pyrolysis temperature is excessively low, the antioxidant itself undergoes pyrolysis at the time of melt-extrusion. Consequently, problems such as a problem that contamination occurs in a relevant step and a problem that the polymer is colored in yellow, tend to easily arise. Thus, an excessively low pyrolysis temperature is not preferable. From this viewpoint, the pyrolysis temperature of the antioxidant is more preferably 280°C or higher, further preferably 300°C or higher, and particularly preferably 320°C or higher. It is preferable that the antioxidant in the present invention is less likely to undergo pyrolysis, and the pyrolysis temperature thereof is preferably high. However, in actuality, the upper limit of the pyrolysis temperature is about 500°C or lower.

The antioxidant has a melting point of preferably 90°C or higher. When the melting point of the antioxidant is excessively low, the antioxidant is melted earlier than the polymer at the time of melt-extrusion, whereby the polymer tends to slip on a screw supply portion of the extruder. This slip leads to problems such as a problem that supply of the polymer becomes unstable and unevenness in the thickness of the sheet increases. From this viewpoint, the melting point of the antioxidant is more preferably 120°C or higher, further preferably 150°C or higher, and particularly preferably 200°C or higher. Meanwhile, when the melting point of the antioxidant is excessively high, the antioxidant becomes less likely to be melted at the time of melt-extrusion, whereby the antioxidant tends to be poorly dispersed in the polymer. This poor dispersion leads to problems such as a problem that the effect due to the addition of the antioxidant is exhibited only locally. From this viewpoint, the melting point of the antioxidant is preferably 300°C or lower, more preferably 250°C or lower, further preferably 220°C or lower, and particularly preferably 170°C or lower.

As the above antioxidant, a commercially available product may be used as is. Preferable examples of the commercially available product include pentaerythritol tetrakis[3-(3,5-di-t-butyl-4-hydroxyphenyl)propionate] (product name IRGANOX1010 manufactured by Ciba Specialty Chemicals K.K.), N,N'-bis[3-(3,5-di-t-butyl-4-hydroxyphenyl)propionyl]hydrazine (product name IRGANOX1024 manufactured by Ciba Specialty Chemicals K.K.), N,N'-hexane-1,6-diylbis[3-(3,5-di-t-butyl-4-hydroxyphenyl)propionamide] (product name IRGANOX1098 manufactured by Ciba Specialty Chemicals K.K.), and the like.

The amount of the contained antioxidant is preferably 0.1% by mass or higher and 8% by mass or lower with the mass of the polystyrene-based resin composition being regarded as a reference. When the antioxidant is contained in an amount that falls in the above numerical range, the heat resistance and the thermal degradation resistance of the sheet can be made high. When the amount of the contained antioxidant is excessively small, the effect due to the addition of the antioxidant tends to become insufficient, and the effect of improving the dielectric breakdown voltage tends to become low. From this viewpoint, the amount of the contained antioxidant is more preferably 0.2% by mass or higher, further preferably 0.3% by mass or higher, and particularly preferably 0.5% by mass or higher. Meanwhile, when the amount of the contained antioxidant is excessively large, the antioxidant tends to be easily aggregated in the sheet, defects due to the antioxidant tend to increase, and the mechanical properties of the sheet become low owing to the defects. From this viewpoint, the amount of the contained antioxidant is more preferably 6% by mass or lower, further preferably 4% by mass or lower, and particularly preferably 2% by mass or lower.

These types of antioxidants may be used singly, or two or more of these types of antioxidants may be used in combination. The case of using two or more of these types of antioxidants in combination may be: the case of using two or more of the aforementioned types of primary antioxidants; the case of using two or more of the aforementioned types of secondary antioxidants; or the case of using one or more of the aforementioned types of primary antioxidants and one or more of the aforementioned types of secondary antioxidants in combination. For example, when two types of antioxidants which are a primary antioxidant and a secondary antioxidant are used in combination, it can be expected to prevent both types of oxidation, i.e., primary oxidation and secondary oxidation. In the present invention, from the viewpoint of enabling further increase in the effect of suppressing thermal degradation at the time of processing, the case of using the aforementioned types of primary antioxidants singly or the case of using two or more of the aforementioned types of primary antioxidants is preferable among the above cases. Out of these cases, the case of using the aforementioned types of phenol-based antioxidants singly or the case of using two or more of the aforementioned types of phenol-based antioxidants is particularly preferable.

The sheet molded body of the present invention may contain components other than the above components, such as a flame retardant, a release agent, a lubricant, a viscosity reducer, and a curing agent. The flame retardant is not particularly limited, and a bromine-containing halogen-based flame retardant, an organic or inorganic phosphoric acid salt, phosphoric acid ester, or phosphorus copolymer, or the like may be suitably used. The flame retardant to be used may be in liquid state or solid state but a flame retardant that is in solid state at normal temperature is preferably used from the viewpoint of long-term stability.

### <Polystyrene-Based Resin Composition>

The polystyrene-based resin composition is a composition at least containing predetermined amounts of the component (A), the component (C), and the component (D) and, as necessary, further containing the component (B) and the component (E). The sheet molded body of the present invention can be manufactured by using the polystyrene-based resin composition. The polystyrene-based resin composition is preferably obtained by blending and kneading these predetermined amounts of components and is preferably made into pellets.

### <Sheet Molded Body>

The sheet molded body of the present invention is an unstretched sheet molded body. The state of being unstretched may not only be a state of being not completely stretched but also be a state where a little residual strain is present. Specifically, in each of a direction (machine direction, MD) parallel to the extrusion direction of the sheet molded body and a direction (transverse direction, TD) perpendicular to said extrusion direction, the sheet molded body has a stretching ratio of preferably 1.3 or lower, more preferably 1.2 or lower, further preferably 1.1 or lower, and most preferably 1.0. When the stretching ratio is set to fall in the aforementioned range, the dimensional change rate of the sheet molded body can be decreased (low thermal shrinkage can be achieved).

The sheet molded body of the present invention has a relative permittivity of 3 or lower at a temperature of 23°C, a relative humidity of 50%, and a frequency of 10 GHz. The relative permittivity is preferably 2.8 or lower and more preferably 2.7 or lower. When the relative permittivity is 3 or lower, the transmission speed for a signal can be increased, and the dielectric loss can be decreased. The lower limit of the relative permittivity is not particularly limited, and the relative permittivity may be industrially 1.0 or higher or 2.0 or higher.

The sheet molded body of the present invention preferably has a dissipation factor of 0.002 or less at a temperature of 23°C, a relative humidity of 50%, and a frequency of 10 GHz. The dissipation factor is more preferably 0.0015 or less and further preferably 0.001 or less. When the dissipation factor is 0.002 or less, the dielectric loss is decreased, and the performance of a circuit board at a high frequency becomes favorable. The lower limit of the dissipation factor is not particularly limited, and the dissipation factor may be 0.0001 or more or may be 0.0002 or more.

The sheet molded body of the present invention has a linear expansion coefficient, in each of the machine direction (MD) and the transverse direction (TD), of preferably 10 to 80 ppm/°C, more preferably 15 to 75 ppm/°C, and further preferably 20 to 70 ppm/°C. In addition, the ratio of the linear expansion coefficient in the MD to the linear expansion coefficient in the TD is preferably 0.6 to 1.4, more preferably 0.65 to 1.35, and further preferably 0.7 to 1.3.

The sheet molded body of the present invention exhibits a dimensional change rate in each of the machine direction (MD) and the transverse direction (TD) when the sheet molded body is heated at 150°C for 30 minutes, and the dimensional change rate is preferably lower than 0.4%. The dimensional change rate is more preferably 0.3% or lower and further preferably 0.2% or lower.

The sheet molded body of the present invention has a thickness of the sheet of preferably 10 µm to 2000 µm, more preferably 20 µm to 1000 µm, further preferably 30 µm to 500 µm, and most preferably 50 µm to 350 µm. When the thickness of the sheet molded body is smaller than 10 µm, the sheet molded body is easily broken. Meanwhile, when the thickness of the sheet molded body is larger than 2000 µm, the molded body is drawn down by the own weight thereof when being extruded as a sheet, or partial shrinkage (sink mark) occurs, resulting in unevenness in the thickness of the sheet.

### EXAMPLES

Hereinafter, the present invention will be more specifically described by means of examples. However, the present invention is not limited by the following examples. In the following examples, parts and % are expressed on a mass basis unless otherwise stated.

### (1) Raw Materials Used in Examples and Comparative Examples

### <Styrene Polymer (A) Having Syndiotactic Structure>

· A1: XAREC (registered trademark) 130ZC (manufactured by Idemitsu Kosan Co., Ltd., containing 100% by mass of syndiotactic polystyrene, having an MFR of 15 g/10 min at a measurement temperature of 300°C and a load of 1.2 kg, and not modified with a compound having a polar group)
· A2: XAREC (registered trademark) 90ZC (manufactured by Idemitsu Kosan Co., Ltd., containing 100% by mass of syndiotactic polystyrene, having an MFR of 9 g/10 min at a measurement temperature of 300°C and a load of 1.2 kg, and not modified with a compound having a polar group)

### <Rubbery Elastic Body (B)>

· B1: Tuftec (registered trademark) H1062 (manufactured by Asahi Kasei Corporation and having a styrene content of 18% by mass and an MFR of 4.5 g/10 min at a measurement temperature of 230°C and a load of 2.16 kg)
· B2: Tuftec (registered trademark) H1041 (manufactured by Asahi Kasei Corporation and having a styrene content of 30% by mass and an MFR of 5.0 g/10 min at a measurement temperature of 230°C and a load of 2.16 kg)
· B3: Tuftec (registered trademark) H1517 (manufactured by Asahi Kasei Corporation and having a styrene content of 43% by mass and an MFR of 3.0 g/10 min at a measurement temperature of 230°C and a load of 2.16 kg)
· B4: Tuftec (registered trademark) H1521 (manufactured by Asahi Kasei Corporation and having a styrene content of 18% by mass and an MFR of 15.0 g/10 min at a measurement temperature of 230°C and a load of 2.16 kg)

### <Fibrous Filler (C)>

. C1: DT09100T(manufactured by TOCHU CORPORATION, having a fiber diameter (diameter) of 9 µm and an average fiber length D50 of 100 µm, and being D-glass)
· C2: PH80M-01N (manufactured by Nippon Electric Glass Co., having a fiber diameter (diameter) of 10 µm and an average fiber length D50 of 80 µm, and being E-glass)
· C3: FH30-01 (manufactured by Central Glass Co., Ltd., having a fiber diameter (diameter) of 11 µm and an average fiber length D50 of 30 µm, and being E-glass)
· C4: ECS301HP-3-H (manufactured by Chongqing Polycomp International Corporation, having a fiber diameter (diameter) of 10 µm and an average fiber length D50 of 3000 µm, and being E-glass)
· C5: ChopVantageHP-3610 (manufactured by Nippon Electric Glass Co., having a fiber diameter (diameter) of 10 µm and an average fiber length D50 of 4500 µm, and being E-glass)

### <Nonfibrous Filler (D)>

· D1: Silica particles: FB-3SDC (manufactured by Denka Company Limited, having an average particle diameter D50 of 3.1 µm)
· D2: Silica particles: FB-7SDC (manufactured by Denka Company Limited, having an average particle diameter D50 of 5.4 µm)
· D3: Silica particles: SFP-130MC (manufactured by Denka Company Limited, having an average particle diameter D50 of 0.6 µm)
· D4: Hollow glass beads: iM-30k (manufactured by 3M Japan Limited, having an average particle diameter D50 of 17 µm)
· D5: Calcium carbonate: WHITON P-30 (manufactured by Shiraishi Calcium Kaisha, Ltd., having an average particle diameter D50 of 4.8 µm)
· D6: Magnesium oxide: RF-98 (manufactured by Ube Material Industries, Ltd., having an average particle diameter D50 of 50 µm)

### <Antioxidant (E)>

· E1: ANOX20 (manufactured by BASF Japan Ltd., Tetrakis[methylene-3-(3,5-di-tert-butyl-4-hydroxyphenyl)propionate]methane)
·E2: PEP-36 (manufactured by ADEKA CORPORATION, 3,9-Bis(2,6-di-tert-butyl-4-methylphenoxy)-2, 4,8,10-tetraoxa-3,9-diphosphaspiro[5.5]undecane)

### <Manufacturing Method for Polystyrene-Based Resin Composition>

Each of polystyrene-based resin compositions (SPS resin composition) was produced in order to obtain a sheet molded body according to the present invention. As components such as SPS (i.e., components (A) to (D) and (E)), corresponding ones of the above various components were blended and kneaded to obtain the composition.

More specifically, these components (A) to (D) and (E) were each supplied from a main or side feeder by using a same-direction twin-screw extruder (at a resin temperature of 300°C) having a diameter of 36 mm and were compounded. The resultant mixture was extruded in the forms of four strands each having a diameter of 4 mm from round dies. Then, the strands were cooled and solidified in a cooling water bath and were cut to obtain columnar pellets of the SPS resin composition.

### <Manufacturing Method for Sheet Molded Body>

The pellets of the SPS resin composition obtained through the above manufacturing method were supplied into a hopper of a single-screw extruder (at a resin temperature of 300°C) having a diameter of 20 mm and were melted again. The melted SPS resin composition was extruded into the shape of a sheet from a T-die. This sheet was held between two rolls (at a temperature of 90°C) so as to be compressed and so as to be cooled and solidified. Then, the sheet was wound at a speed of 1 m/min around a paper tube having a diameter of 80 mm. Thus, an unstretched SPS sheet having a thickness of 300 µm was obtained. At this time, the windability of the unstretched SPS sheet around a roll was evaluated as follows. That is, in a case where sticking to a chill roll was not noticed and unevenness in the thickness of the sheet surface was not noticed, the unstretched SPS sheet was evaluated as (A). Meanwhile, in a case where sticking to the roll or unevenness in the thickness of the sheet surface was noticed, the unstretched SPS sheet was evaluated as (B). Meanwhile, in a case where sticking to the roll did not occur but unevenness in the thickness of the sheet surface or a minute crack was noticed, the unstretched SPS sheet was evaluated as (C). Meanwhile, in a case where the unstretched SPS sheet was not able to be wound owing to sticking to the roll or breakage of the sheet surface, the unstretched SPS sheet was evaluated as (D). Hereinafter, a direction parallel to the extrusion direction of the sheet is defined as MD, and a direction perpendicular to said extrusion direction is defined as TD.

### <Heat Treatment and Humidity Adjustment Step>

Heat treatment of the obtained unstretched SPS sheet makes it possible to increase the degree of crystallinity of the component (A) contained in the SPS sheet and improve the solder heat resistance of the SPS sheet.

The SPS sheet obtained through the above manufacturing method was held between a commercially available polyimide film (Upilex manufactured by UBE Corporation) and a silicon sheet and was heated under pressure by using an oil-pressure hand press machine (under a vacuum, at a temperature of 200°C, for 30 minutes, and at a pressure of 2 MPa). The obtained SPS sheet subjected to the heat treatment (hereinafter, written as "sheet molded body") was subjected to humidity adjustment treatment for 24 hours in an environment at 23°C and a relative humidity of 50%, whereby influence of humidity was eliminated. Thus, a sample that hardly varied owing to external factors was obtained. At this time, the outer appearance of the sheet molded body was observed. In a case where obvious swell was noticed on the observed surface, the sheet molded body was evaluated as (C). Meanwhile, in a case where no swell was noticed but transfer unevenness due to gas generated through decomposition of the resin at the time of hot-pressing was noticed on a part of the sheet molded body, the sheet molded body was evaluated as (B). Meanwhile, in a case where a clear glossy surface or an evenly matte surface was obtained, the sheet molded body was evaluated as (A).

In order to confirm that crystallization of the sheet molded body had been completed, an evaluation was performed according to JIS K 7121 (2012) by using a differential scanning calorimeter (DSC7020 manufactured by Hitachi High-Tech Corporation). More specifically, 5 mg of the sheet molded body was put into an aluminum pan. It was confirmed that no exothermic peak was observed in a temperature range of 100 to 220°C when the temperature was increased from room temperature at a speed of 20°C/min. Thus, it was confirmed that crystallization had been completed by heat treatment at the time of pressing.

In the following paragraphs, description will be given in relation to evaluations of physical properties in items 1 to 4 performed on the sheet molded bodies having been subjected to the heat treatment and the humidity adjustment treatment.

Meanwhile, in the case of manufacturing a biaxially stretched sheet molded body, an unstretched SPS sheet having a thickness of 500 µm was obtained through the same method as the above method, and then simultaneous biaxial stretching was performed (at a temperature of 110°C, a stretching ratio of 3.3 × 3.4 (MD × TD), and a stretching speed of 500%/min). Thereafter, relaxation-type heat treatment was performed (at a temperature of 230°C and a relaxation ratio of 0.95 × 0.95 (MD × TD)) in a heat drying oven, whereby a biaxially stretched SPS sheet having a thickness of the sheet of 50 µm was obtained.

### <Evaluation Methods>

### 1. Dielectric Characteristics

Each of the sheet molded bodies was cut so as to produce a strip-shaped test piece (3 mm in MD × 80 mm in TD). Then, in a test environment at a temperature of 23°C and a humidity of 50%, each of dielectric characteristics (relative permittivity (Dk) and dissipation factor (Df)) of the test piece at a frequency of 10 GHz was measured a total of 5 times, and the average value of the measured values was calculated (according to JIS C 2565). As measurement devices, a network analyzer MS46122B manufactured by ANRITSU CORPORATION and a cavity resonator manufactured by AET, INC., were used. In a case where the relative permittivity (Dk) was 3 or lower, the sheet molded body was evaluated as being acceptable (A). Meanwhile, in a case where the relative permittivity (Dk) was higher than 3, the sheet molded body was evaluated as being unacceptable (B). In addition, in a case where the dissipation factor (Df) was 0.002 or lower, the sheet molded body was evaluated as being acceptable (A). Meanwhile, in a case where the dissipation factor (Df) was higher than 0.002, the sheet molded body was evaluated as being unacceptable (B).

### 2. Linear Expansion Coefficient (TMA)

Each of the sheet molded bodies was cut so as to produce strip-shaped test pieces (3 mm in width direction × 25 mm in longitudinal direction) which were: an MD test piece, the longitudinal direction of which was the MD; and a TD test piece, the longitudinal direction of which was the TD. Then, the linear expansion coefficient of each of the obtained test pieces, i.e., the MD test piece and the TD test piece, was measured 5 times, and the average value of the measured values was calculated (according to JIS K 7197). As a measurement device, TMA7100 manufactured by Hitachi High-Tech Corporation was used to perform the measurement under a condition of a load of 2 gf/mm. Regarding a reading range of measurement results, the measurement was performed in a temperature range of 23°C to 80°C, and, in a case where the linear expansion coefficients of both the MD test piece and the TD test piece were 10 ppm/°C or higher and 80 ppm/°C or lower, the sheet molded body was evaluated as being acceptable.

### 3. Dimensional Change Rate

Each of the sheet molded bodies was cut so as to produce a rectangular test piece (180 mm in MD × 130 m in TD). On a surface of the test piece, straight lines were drawn so as to form a quadrangle (120 mm long in MD × 70 mm long in TD), the straight lines being drawn so as to be parallel to the MD and the TD and intersect with each other at midpoints. Each of the lengths of the straight lines in the MD and the TD on the test piece was measured.

Subsequently, in a hot-air-circulation-type oven in which setting was performed to obtain an atmosphere at 150°C, the test piece was left at rest for 30 minutes in a state of being hung in midair with one corner thereof being supported. Then, the test piece was taken out from the oven and was cooled by being left at rest for 24 hours in an environment of a temperature of 23°C and a humidity (relative humidity) of 50%, whereby influence of moisture content was eliminated. Thereafter, each of the lengths of the straight lines in the MD and the TD was measured, a change amount relative to the corresponding length measured before the test performed at 150°C for 30 minutes was obtained, and the percentage of each of the change amounts relative to the corresponding pre-test length was obtained as a heat shrinkage rate. A heat shrinkage rate having a positive value means that the test piece shrunk. In a case where the heat shrinkage rate had an absolute value of lower than 0.4%, the sheet molded body was evaluated as being acceptable (A). Meanwhile, in a case where the heat shrinkage rate had an absolute value of 0.4% or higher, the sheet molded body was evaluated as being unacceptable (B).

### 4. Soldering Heat Resistance Test

Each of the sheet molded bodies was cut so as to produce a test piece (50 mm in MD × 50 mm in TD). Then, the test sheet was floated for 120 seconds in a solder bath heated to 260°C, and the extent of deformation and presence/absence of abnormality in the outer appearance of the test sheet such as a swell were checked through visual observation. In a case where neither a deformation nor a swell in the outer appearance of the test sheet was noticed at all, the sheet molded body was evaluated as (A). Meanwhile, in a case where neither an outstanding deformation nor an outstanding swell in the outer appearance of the test sheet was noticed, the sheet molded body was evaluated as being acceptable (B). Meanwhile, in a case where a partial wrinkle in the test sheet was noticed, the sheet molded body was evaluated as being barely acceptable (C). Meanwhile, in a case where an outstanding deformation or an outstanding abnormality, i.e., swell, in the outer appearance of the test sheet was noticed, the sheet molded body was evaluated as being unacceptable (D).

### (Examples 1 to 23)

In each of Examples 1 to 12 with the predetermined amounts of the component (A), the component (C), and the component (D) being contained, each of the required physical properties can be satisfied, and the performances are exhibited with excellent overall balance. The results are indicated in Table 1 and Table 2.

### (Comparative Examples 1 to 8)

When the component (A), the component (C), and the component (D) are added at such levels to be excessive or insufficient, some of the physical properties cannot be satisfied and the sheet molded body lacks in appearance quality as in each of Comparative Examples 1 to 12. The results are indicated in Table 3.

**[Table 1]**

| | | | | Examples | | | | | | | | | | | |
|---|---|---|---|---|---|---|---|---|---|---|---|---|---|---|---|
| | | | | 1 | 2 | 3 | 4 | 5 | 6 | 7 | 8 | 9 | 10 | 11 | 12 |
| Composition (parts by weight) | Styrene polymer (A) having a syndiotactic structure | A1 | 130ZC | 78 | 70 | | | | | | | | | | |
| | | A2 | 90ZC | | | 70 | 70 | 70 | 70 | 62 | 70 | 70 | 70 | 70 | 70 |
| | Rubbery elastic body (B) | B1 | H1062 | | 8 | 8 | 8 | 8 | 8 | 16 | | | | 8 | 8 |
| | | B2 | H1041 | | | | | | | | 8 | | | | |
| | | B3 | H1517 | | | | | | | | | 8 | | | |
| | | B4 | H1521 | | | | | | | | | | 8 | | |
| | Fibrous filler (C) | C1 | HDT09100T | 12 | 12 | 12 | 12 | 12 | 12 | 12 | 12 | 12 | 12 | 12 | 12 |
| | | C2 | EPH80M-01N | | | | | | | | | | | | |
| | | C3 | EFH30-01 | | | | | | | | | | | | |
| | | C4 | ECS301 HP-3-H | | | | | | | | | | | | |
| | | C5 | HP-3610 | | | | | | | | | | | | |
| | Nonfibrous Filler (D) | D1 | FB-3SDC | 10 | 10 | 10 | 10 | 10 | 10 | 10 | 10 | 10 | 10 | | |
| | | D2 | FB-7SDC | | | | | | | | | | | 10 | |
| | | D3 | SFP-1 30MC | | | | | | | | | | | | 10 |
| | | D4 | iM-30k | | | | | | | | | | | | |
| | | D5 | P-30 | | | | | | | | | | | | |
| | | D6 | RF-98 | | | | | | | | | | | | |
| | Antioxidant (E) | E1 | ANOX20 | 0.2 | 0.2 | 0.2 | 0.2 | | | 0.2 | 0.2 | 0.2 | 0.2 | 0.2 | 0.2 |
| | | E2 | PEP-36 | 0.2 | 0.2 | 0.2 | | 0.2 | | 0.2 | 0.2 | 0.2 | 0.2 | 0.2 | 0.2 |
| Manufacturing method for sheet | | | | Unstretched | Unstretched | Unstretched | Unstretched | Unstretched | Unstretched | Unstretched | Unstretched | Unstretched | Unstretched | Unstretched | Unstretched |
| Properties | Windability around a roll | | | B | A | A | A | A | A | A | A | A | A | A | A |
| | Outer appearance of the sheet molded body | | | A | A | A | B | B | C | A | A | A | B | A | A |
| | Thickness [ *µ* m] | | | 300 | 300 | 300 | 300 | 300 | 300 | 300 | 300 | 300 | 300 | 300 | 300 |
| | 1. Dielectric Characteristics | | Dk | 2.56 | 2.54 | 2.54 | 2.54 | 2.54 | 2.54 | 2.54 | 2.58 | 2.63 | 2.54 | 2.56 | 2.60 |
| | | | Df | 0.0007 | 0.0007 | 0.0007 | 0.0007 | 0.0007 | 0.0007 | 0.0007 | 0.0007 | 0.0008 | 0.0007 | 0.0007 | 0.0007 |
| | 2. Linear Expansion Coefficient [ppm/°C] | | CTE (MD) | 51 | 53 | 55 | 54 | 56 | 55 | 60 | 54 | 52 | 55 | 53 | 55 |
| | | | CTE (TD) | 68 | 70 | 68 | 69 | 70 | 70 | 70 | 69 | 68 | 68 | 65 | 64 |
| | | | CTE (MD/TD) | 0.75 | 0.76 | 0.81 | 0.78 | 0.80 | 0.79 | 0.86 | 0.78 | 0.76 | 0.81 | 0.82 | 0.86 |
| | 3. Dimensional Change Rate [%] | | MD | -0.15 | -0.18 | -0.18 | -0.17 | -0.17 | -0.19 | -0.16 | -0.17 | -0.16 | -0.18 | -0.05 | -0.10 |
| | | | TD | +0.12 | +0.14 | +0.14 | +0.15 | +0.15 | +0.16 | -0.25 | +0.12 | +0.19 | +0.14 | +0.06 | +0.20 |
| | 4. Solder heat resistance | | - | B | B | B | B | B | B | B | B | B | B | B | B |

**[Table 2]**

| | | | | Examples | | | | | | | | | | |
|---|---|---|---|---|---|---|---|---|---|---|---|---|---|---|
| | | | | 13 | 14 | 15 | 16 | 17 | 18 | 19 | 20 | 21 | 22 | 23 |
| Composition (parts by weight) | Styrene polymer (A) having a syndiotactic structure | A1 | 130ZC | | | | | | | | | | | |
| | | A2 | 90ZC | 70 | 70 | 70 | 60 | 60 | 54 | 70 | 70 | 70 | 70 | 42 |
| | Rubbery elastic body (B) | B1 | H1062 | 8 | 8 | 8 | 8 | 8 | 24 | 8 | 8 | 8 | 8 | 16 |
| | | B2 | H1041 | | | | | | | | | | | |
| | | B3 | H1517 | | | | | | | | | | | |
| | | B4 | H1521 | | | | | | | | | | | |
| | Fibrous filler (C) | C1 | HDT09100T | 12 | 12 | | 22 | 12 | 12 | | | | 12 | 12 |
| | | C2 | EPH80M-01N | | | 12 | | | | | | | | |
| | | C3 | EFH30-01 | | | | | | | 12 | | | | |
| | | C4 | ECS301HP-3-H | | | | | | | | 12 | | | |
| | | C5 | HP-3610 | | | | | | | | | 12 | | |
| | Nonfibrous Filler (D) | D1 | FB-3SDC | | | 10 | 10 | 20 | 10 | 10 | | 10 | | 30 |
| | | D2 | FB-7SDC | | | | | | | | | | | |
| | | D3 | SFP-130MC | | | | | | | | 10 | | | |
| | | D4 | iM-30k | 10 | | | | | | | | | | |
| | | D5 | P-30 | | 10 | | | | | | | | | |
| | | D6 | RF-98 | | | | | | | | | | 10 | |
| | Antioxidant (E) | E1 | ANOX20 | 0.2 | 0.2 | 0.2 | 0.2 | 0.2 | 0.2 | 0.2 | 0.2 | 0.2 | 0.2 | 0.2 |
| | | E2 | PEP-36 | 0.2 | 0.2 | 0.2 | 0.2 | 0.2 | 0.2 | 0.2 | 0.2 | 0.2 | 0.2 | 0.2 |
| Manufacturing method for sheet | | | | Unstretched | Unstretched | Unstretched | Unstretched | Unstretched | Unstretched | Unstretched | Unstretched | Unstretched | Unstretched | Unstretched |
| Properties | Windability around a roll | | | A | A | A | A | A | B | A | B | C | B | B |
| | Outer appearance of the sheet molded body | | | A | A | A | A | A | A | A | A | A | A | A |
| | Thickness [*µ* m] | | | 300 | 300 | 300 | 300 | 300 | 300 | 300 | 300 | 300 | 300 | 300 |
| | 1. Dielectric Characteristics | | Dk | 2.35 | 2.72 | 2.65 | 2.66 | 2.64 | 2.55 | 2.69 | 2.71 | 2.71 | 2.74 | 2.76 |
| | | | Df | 0.0005 | 0.0008 | 0.0009 | 0.0010 | 0.0008 | 0.0009 | 0.0011 | 0.0012 | 0.0012 | 0.0010 | 0.0014 |
| | 2. Linear Expansion Coefficient [ppm/°C] | | CTE (MD) | 56 | 52 | 54 | 43 | 51 | 78 | 64 | 44 | 42 | 53 | 47 |
| | | | CTE (TD) | 77 | 74 | 66 | 60 | 56 | 74 | 71 | 69 | 70 | 74 | 45 |
| | | | CTE (MD/TD) | 0.73 | 0.71 | 0.82 | 0.72 | 0.91 | 1.05 | 0.90 | 0.64 | 0.60 | 0.72 | 1.04 |
| | 3. Dimensional Change Rate [%] | | MD | -0.06 | -0.10 | -0.20 | -0.06 | -0.09 | -0.39 | -0.22 | -0.05 | -0.05 | -0.17 | -0.03 |
| | | | TD | +0.05 | +0.10 | +0.10 | +0.09 | +0.04 | -0.35 | . +0.18 | +0.22 | +0.22 | +0.15 | +0.02 |
| | 4. Solder heat resistance | | - | B | B | B | B | B | C | C | A | A | C | B |

**[Table 3]**

| | | | | Comparative Examples | | | | | | | |
|---|---|---|---|---|---|---|---|---|---|---|---|
| | | | | 1 | 2 | 3 | 4 | 5 | 6 | 7 | 8 |
| Composition (parts by weight) | Styrene polymer (A) having a syndiotactic structure | A1 | 130ZC | | | | | | | | |
| | | A2 | 90ZC | 70 | 70 | 88 | 88 | 90 | 90 | 82 | 45 |
| | Rubbery elastic body (B) | B1 | H1062 | | | | | | | 8 | |
| | | B2 | H1041 | | | | | | | | |
| | | B3 | H1517 | | | | | | | | |
| | | B4 | H1521 | | | | | | | | |
| | Fibrous filler (C) | C1 | HDT09100T | | | 12 | 12 | | | | |
| | | C2 | EPH80M-01N | | | | | | | | 50 |
| | | C3 | EFH30-01 | | | | | | | | |
| | | C4 | ECS301 HP-3-H | | | | | | | | |
| | | C5 | HP-3610 | | | | | | | | |
| | Nonfibrous Filler (D) | D1 | FB-3SDC | | | | | 10 | 10 | 10 | 5 |
| | | D2 | FB-7SDC | | | | | | | | |
| | | D3 | SFP-130MC | | | | | | | | |
| | | D4 | iM-30k | | | | | | | | |
| | | D5 | P-30 | | | | | | | | |
| | | D6 | RF-98 | | | | | | | | |
| | Antioxidant (E) | E1 | ANOX20 | 0.2 | 0.2 | 0.2 | 0.2 | 0.2 | 0.2 | 0.2 | 0.2 |
| | | E2 | PEP-36 | 0.2 | 0.2 | 0.2 | 0.2 | 0.2 | 0.2 | 0.2 | 0.2 |
| Manufacturing method for sheet | | | | Unstretched | Biaxially stretched | Unstretched | Biaxially stretched | Unstretched | Biaxially stretched | Unstretched | Unstretched |
| Properties | Windability around a roll | | | B | B | B | D | B | B | A | B |
| | Outer appearance of the sheet molded body | | | A | A | A | - | A | A | A | B |
| | Thickness [*µ* m] | | | 300 | 50 | 300 | - | 300 | 50 | 300 | 300 |
| | 1. Dielectric Characteristics | | Dk | 2.30 | 2.28 | 2.48 | - | 2.43 | 2.41 | 2.35 | 3.54 |
| | | | Df | 0.0004 | 0.0004 | 0.0007 | - | 0.0006 | 0.0005 | 0.0005 | 0.0021 |
| | 2. Linear Expansion Coefficient [ppm/°C] | | CTE (MD) | 91 | 66 | 41 | - | 78 | 40 | 83 | 22 |
| | | | CTE (TD) | 88 | 48 | 82 | - | 74 | 38 | 74 | 52 |
| | | | CTE (MD/TD) | 1.03 | 1.38 | 0.50 | - | 1.05 | 1.05 | 1.12 | 0.42 |
| | 3. Dimensional Change Rate [%] | | MD | -0.50 | -1.40 | -0.25 | - | -0.45 | -1.15 | -0.48 | -0.06 |
| | | | TD | +0.28 | -1.30 | +0.24 | - | +0.23 | -1.02 | -0.25 | 0.08 |
| | 4. Solder heat resistance | | - | D | B | B | - | D | B | D | B |

### INDUSTRIAL APPLICABILITY

As is obvious from the above description, in the present invention, each of the sheet molded bodies described in the Examples exhibits excellent characteristics, i.e., excellent dielectric characteristics, excellent linear expansion coefficient, excellent dimensional stability, and excellent solder heat resistance. Thus, use of the sheet molded body is expected to be extended to high-frequency circuit boards. Specifically, the sheet molded body of the present invention can be expected to be used in, for example, an electronic part and an antenna part for a communication device for which 5G is required.

## Claims

1. A sheet molded body comprising:
a styrene-based polymer (A) having a syndiotactic structure;
a fibrous filler (C); and
a nonfibrous filler (D), wherein
the sheet molded body is an unstretched sheet molded body, contains the fibrous filler (C) in amount of 1 to 50 parts by mass per 100 parts by mass of the styrene-based polymer (A) having the syndiotactic structure, and has a relative permittivity, in a frequency band of 10 GHz, of 3 or lower.

2. The sheet molded body according to claim 1, further comprising a rubbery elastic body (B), wherein
the sheet molded body contains the rubbery elastic body (B) in amount of 1 to 40 parts by mass per 100 parts by mass of the styrene-based polymer (A) having the syndiotactic structure.

3. The sheet molded body according to claim 1 or 2, wherein
the fibrous filler (C) is made of glass fibers having an average fiber length D50 of 40 to 4000 µm.

4. The sheet molded body according to any one of claims 1 to 3, wherein
the nonfibrous filler (D) is a particle-form or spherical-form filler having an average particle diameter D50 of 0.1 to 45 µm.

5. The sheet molded body according to any one of claims 1 to 4, wherein
the rubbery elastic body (B) contains a styrene-based or olefin-based thermoplastic elastomer.

6. The sheet molded body according to any one of claims 1 to 5, wherein
the sheet molded body has a linear expansion coefficient, in each of a machine direction (MD) and a transverse direction (TD), of 10 to 80 ppm/°C, and
a ratio of the linear expansion coefficient in the MD to the linear expansion coefficient in the TD falls in a range of 0.6 to 1.4.

7. The sheet molded body according to any one of claims 1 to 6, the sheet molded body exhibiting a dimensional change rate when the sheet molded body is heated at 150°C for 30 minutes, the dimensional change rate having an absolute value of lower than 0.4%.
